Europäisches Patentamt

(19) European Patent Office

Office européen des brevets

(11) EP 0 872 531 A1

(12) EUROPEAN PATENT APPLICATION

(43) Date of publication:
21.10.1998 Bulletin 1998/43

(51) Int. Cl.⁶: **C09J 7/02**, C09J 5/02,
C08F 20/18, H05K 7/20,
H01L 23/373

(21) Application number: 98106970.1

(22) Date of filing: 16.04.1998

(84) Designated Contracting States:
AT BE CH CY DE DK ES FI FR GB GR IE IT LI LU
MC NL PT SE
Designated Extension States:
AL LT LV MK RO SI

(30) Priority: 17.04.1997 JP 99884/97

(71) Applicant:
NITTO DENKO CORPORATION
Osaka (JP)

(72) Inventors:
• Kitakura, Kazuyuki
Ibaraki-shi, Osaka (JP)
• Oura, Masahiro
Ibaraki-shi, Osaka (JP)
• Yoshikawa, Takao
Ibaraki-shi, Osaka (JP)
• Muta, Shigeki
Ibaraki-shi, Osaka (JP)

(74) Representative:
Grünecker, Kinkeldey,
Stockmair & Schwanhäusser
Anwaltssozietät
Maximilianstrasse 58
80538 München (DE)

(54) **Method for producing heat-conductive and pressure-sensitive adhesive sheets**

(57) Heat-conductive and pressure-sensitive adhesive sheets being excellent in heat resistance and free from any troubles such as corrosion of electronic parts due to organic solvents or swelling, peeling or deviation caused by vaporization and swelling at high temperatures, having excellent adhesion of the adhesive layer to the base material and thus scarcely undergoing anchoring fracture between the base material and the adhesive layer, and, therefore, being usable in fixing electronic parts to heat-radiating members, or fixing members in various fields including building materials, vehicles, aircrafts and ships. These heat-conductive and pressure-sensitive adhesive sheets can be produced by high-frequency sputter etching one or both of the surfaces of an electrical insulating plastic film, applying a polymerizable composition containing a monomer containing an alkyl (meth)acrylate as the main component or a partially polymerized product thereof, onto the sputter-etched surface(s), and polymerizing the monomer or the partially polymerized product with UV-irradiation or radiation to thereby form a layer of a heat-conductive and pressure-sensitive adhesive composition containing the alkyl (meth)acrylate polymer.

**Description**

FIELD OF THE INVENTION

This invention relates to a method for producing heat-conductive and pressure-sensitive adhesive sheets in the form of sheets, tapes, etc., which are useful for fixing electronic parts, in particular, fixing an electronic part to a heat-radiating member, and for fixing members in various fields such as building materials, vehicles, aircrafts and ships.

BACKGROUND OF THE INVENTION

With an increase of integration of IC circuits, heat value is increased in electronic parts such as hybrid packages, multimodules, and sealed-type integrated circuits with plastics and metals. Since the increase of temperature due to the increased heat value may cause malfunction of the electronic parts, a countermeasure of preventing the malfunction by attaching a heat-radiating member such as a heat sink to the electronic part has been taken.

As a method for providing electronic parts with heat-radiating members, a method which comprises using an adhesive prepared by adding aluminum powder etc. to a composition comprising a polymerizable acrylate monomer and a free radical initiator is proposed in U.S. Patent 4,722,960. In this method, after the adhesive is applied onto one or both of the electronic part and the heat-radiating member, it is necessary to effect curing treatment using a primer or blocking oxygen. Such an adhesion treatment needs a long time and much labor, and the materials to be adhered have to be fixed temporally until the completion of curing, thereby resulting in poor efficiency in producing the electronic devices.

Further, U.S. Patent 4,606,962 proposes to use an adhesive tape which has an adhesive layer containing silver grains having a diameter exceeding the thickness of the layer. When silver grains are added in the process of the preparation of the adhesive composition, the viscosity of the composition is extremely increased and, as a result, the composition becomes poor in flowability and handling properties, in particular, coating workability. When such a composition is formed into a tape, no thickness accuracy can be achieved, and in the worst case, no tape can be obtained. In addition, there arises another problem that the tape thus obtained is unusable in the case where electrical insulation is needed.

In contrast, there have been proposed some methods which comprise using pressure-sensitive adhesive tapes containing heat-conductive and electrical insulating particles in the adhesive. When inserted between electronic parts to be electrically insulated and heat-radiating members, these adhesive tapes can adhere and fix them utilizing the pressure-sensitive adhesion without showing any trouble in handling properties, etc., which the adhesive tapes containing silver grains cause.

In some of these heat-conductive and pressure-sensitive adhesive tapes, no supporting base material is required as disclosed in JP-A-6-88061 (the term "JP-A" as used herein means an "unexamined published Japanese patent application") which corresponds to EP 566093 A1. However, the electrical insulation properties (i.e., volume resistivity, breakdown voltage) of these heat-conductive and pressure-sensitive adhesive tapes are seriously damaged, when the terminal of an electronic part invades the adhesive layer. Thus, these tapes are unusable in cases with the need of high reliability as electrical insulating materials.

To establish sufficient usability as electrical insulating materials and desirable tape strength for fully adhering and fixing electronic parts to heat-radiating members without causing the above-mentioned troubles, it is preferable to use a heat-conductive pressure-sensitive adhesive tape prepared by using a highly heat-resistant, electrical insulating plastic film as a base material, and forming thereon a layer of a pressure-sensitive adhesive composition containing heat-conductive and electrical insulating particles.

As tapes of the above-mentioned type, there are some products in which an acrylic pressure-sensitive adhesive containing heat-conductive, electrical insulating particles is applied onto a polyimide film having heat-conductive, electrical insulating particles dispersed therein. However, the tape suffers from some troubles in heat resistance and frequently undergoes anchoring fracture between the film and the adhesive layer, in particular, at high temperatures. Moreover, the tape contains an unevaporated organic solvent, since a pressure-sensitive adhesive of the organic solvent solution type is employed therein, which sometimes results in troubles such as corrosion of electronic parts or swelling, peeling or deviation caused by vaporization and expansion at high temperatures.

On the other hand, as a heat-conductive interfacial material located between a heat source and a radiator, JP-A-5-198709 (U.S. Patent 5,213,868) proposes a heat-conductive material comprising an electrical insulating plastic film (made of nylon, polyesters, polyimides, polyamides, etc.) having a pressure-sensitive acrylic adhesive layer formed thereon and perforated, embossed or grooved so as to remove the air between the heat source and the radiator. However, these materials are also unsatisfactory in heat resistance and fail to achieve any sufficient effects as an interfacial material.

Further, JP-B-2-24383 proposes base plates for mounting solid electronic devices in which a silicone pressure-sensitive adhesive is applied onto a polyimide film having heat-conductive, electrical insulating particles dispersed therein (the term "JP-B" as used herein means an "examined Japanese patent publication"). However, silicone pressure-sensitive adhesives are poor in the capability of adhering and fixing electronic parts to heat-radiating members and it is finally needed therefore to use screws, springs, etc. for fixation. In addition, there is a risk that low-molecular weight silicone might cause defects in the terminals of electronic parts. Thus, there is a tendency to avoid using silicone polymers within base plates of electronic parts.

Namely, electrical insulating, heat-conductive and pressure-sensitive adhesive tapes are advantageous in that electronic parts to be insulated can be easily adhered and fixed to heat-radiating members without resort to any troublesome and time-consuming adhesion treatment. However, silicone pressure-sensitive adhesives are poor in the adhesion/fixation force, while acrylic pressure-sensitive adhesives are excellent in the adhesion/fixation force but have only poor heat resistance. In particular, these tapes frequently undergo anchoring fracture between the base material and the adhesive layer. In the case of adhesives of the organic solvent solution type, the unevaporated solvents sometimes result in troubles such as corrosion of electronic parts or swelling, peeling or deviation caused by vaporization and expansion at high temperatures. In order to apply these tapes to fixation of electronic parts to heat-radiating members, it is strongly desired to overcome these problems.

## SUMMARY OF THE INVENTION

Under these circumstances, the present invention aims at providing heat-conductive and pressure-sensitive adhesive sheets comprising an acrylic pressure-sensitive adhesive being superior in adhesion/fixation force to a silicone pressure-sensitive adhesive, which are excellent in heat resistance and free from any troubles such as corrosion of electronic parts due to organic solvents or swelling, peeling or deviation caused by vaporization and expansion at high temperatures, scarcely undergo anchoring fracture between the base material and the adhesive layer and, therefore, are usable in fixing electronic parts to heat-radiating members or fixing members in various fields including building materials, vehicles, aircrafts and ships.

In order to achieve the above-mentioned object, the present inventors have conducted extensive studies and, as a result, found out that heat-conductive and pressure-sensitive adhesive sheets being free from any troubles such as corrosion of electronic parts due to organic solvents or swelling, peeling or deviation caused by vaporization and expansion at high temperatures, having improved adhesion between the adhesive layer and the base material, scarcely undergoing anchoring fracture between the base material and the adhesive layer, and having remarkably excellent heat resistance, can be obtained by using an electrical insulating plastic film as a base material, high-frequency sputter etching one or both of the surfaces of the film, applying a solvent-free, polymerizable composition containing an acrylic monomer optionally having been polymerized partially onto the sputter-etched surface(s) and then polymerizing the monomer to form a layer of an acrylic pressure-sensitive adhesive.

Accordingly, the present invention relates to a method for producing heat-conductive and pressure-sensitive adhesive sheets which comprises high-frequency sputter etching one or both of the surfaces of an electrical insulating plastic film as a base material, applying a polymerizable composition containing a monomer containing an alkyl (meth)acrylate as the main component or a partially polymerized product of the monomer, onto the sputter-etched surface(s), and polymerizing the monomer or the partially polymerized product with irradiation of an ultraviolet ray (UV) or radiation to thereby form a layer of a heat-conductive and pressure-sensitive adhesive composition containing the alkyl (meth)acrylate polymer.

## DETAILED DESCRIPTION OF THE INVENTION

Examples of the base material to be used in the present invention include electrical insulating plastic films made of polyesters, polyimides(amides), etc., usually having a thickness of 12 $\mu$m to 4 mm. Among these plastic films, it is preferable from the viewpoint of heat resistance to use polyimide(amide) films, i.e., polyimide films or polyimide-amide films. Moreover, plastic films containing heat-conductive, electrical insulating fillers therein are preferable from the viewpoint of heat conductivity.

These polyimide(amide) films are made of imide (amide) compounds of, for example, an aromatic dianhydride (such as pyromellitic dianhydride) with aromatic diamines (such as 4,4'-diaminodiphenyl ether and paraphenylenediamine) and are commercially available as films having excellent heat resistance. Polyimides(amides) having excellent heat resistance are described in, for example, U.S. Patents 2,149,286, 2,407,896, 2,421,024, 2,502,576 and 2,710,853.

Examples of the heat-conductive, electrical insulating filler include ceramics and metal oxides having electrical insulating properties such as $SiO_2$, $TiB_2$, BN, $Si_3N_4$, $TiO_2$, MgO, NiO, CuO, $Al_2O_3$, and $Fe_2O_3$. Among all, it is preferable from the viewpoints of heat-conductivity and availability to use BN or $Al_2O_3$. Such a filler usually has an average particle diameter of from 2 to 250 $\mu$m, preferably from 1 to 100 $\mu$m and still preferably from 2 to 10 $\mu$m. These particles may be in any form such as spheres, needles, flakes or stars. The content thereof in the film is generally from 2 to 50 % by volume, preferably from 10 to 35 % by volume.

In the present invention, either one or both of the surfaces of the above-mentioned plastic film are subjected to high frequency sputter etching. By this treatment, hydrophilic groups are formed on the base material made of the above-mentioned plastic film. These hydrophilic groups largely contribute to the improvement in the adhesion of the acrylic pressure-sensitive adhesive layer, formed by applying the polymerizable composition thereonto, followed by polymerization, and thus make it possible to give heat-conductive and pressure-sensitive adhesive sheets scarcely undergoing anchoring fracture between the adhesive layer and the base material and being excellent in heat resistance. The high frequency sputter etching may be performed under such conditions that the sputter etching per se can conduct stable and continuous discharge without largely lowering the etching speed. It is preferably performed under an atmospheric pressure of from 0.0005 to 0.5 Torr, still preferably from 0.001 to 0.15 Torr. The atmospheric gas can be an arbitrary one, but it is preferable to avoid using a highly active gas (such as chlorine gas and fluorine gas) or an organic gas which causes discharge polymerization in the step of the sputter etching. In practice, inert gases such as argon, air, nitrogen, steam, carbon dioxide, etc. can be used.

The frequency in the sputter etching is from several hundred KHz to several ten MHz. This treatment is practically carried out at a frequency of 13.56 MHz, which is industrially assigned in Japan. The discharge power is from 0.1 to 5 Watt/cm$^2$. Since the treatment time is prolonged with an decrease in the discharge power, it is recommended to employ a high discharge power so as to complete the treatment within a short period of time. The degree of the treatment on the surface is roughly expressed as the product of the discharge power and the treatment time.

In the present invention, the polymerizable composition to be applied onto the above-mentioned high frequency sputter-etched surface(s) is one containing a monomer containing an alkyl (meth)acrylate as the main component and no solvent or a partially polymerized product thereof. Typical examples of the composition include those composed of: a) 100 parts by weight of a monomer which comprises from 70 to 100 % by weight of an alkyl (meth)acrylate having 2 to 14, on average, carbon atoms in the alkyl group and from 0 to 30 % by weight of a monomer for modification copolymerizable therewith or a partially polymerized product thereof; b) from 0.02 to 5 parts by weight of a polyfunctional (meth)acrylate as a crosslinking agent; c) from 0.01 to 5 parts by weight of a photopolymerization initiator; and d) from 10 to 300 parts by weight of a heat-conductive, electrical insulating filler.

Examples of the alkyl (meth)acrylate having 2 to 14 carbon atoms in the alkyl group on average as the main component for component a) include butyl (meth)acrylate, isononyl (meth)acrylate, isooctyl (meth)acrylate and 2-ethylhexyl(meth)acrylate. The content thereof is generally from 70 to 100 % by weight, preferably from 85 to 95 % by weight based on the total amount of the monomers.

Examples of the monomer for modification copolymerizable with the above-mentioned monomer include (meth)acrylic acid, itaconic acid, sulfopropyl (meth)acrylate, hydroxyalkyl (meth)acrylate, cyanoalkyl (meth)acrylate, (meth)acrylamide, substituted (meth)acrylamide, N-vinylcaprolactam, (meth)acrylonitrile, 2-methoxyethyl (meth)acrylate, glycidyl (meth)acrylate, caprolactam-modified (meth)acrylate, caprolactam-modified hydroxyethyl (meth)acrylate, vinyl acetate and styrene. These monomers for modification are appropriately used to improve the adhesion and regulate the glass transition temperature of the polymer so as to increase the cohesive force and heat resistance of the polymer. The content thereof is from 0 to 30 % by weight, preferably from 5 to 15 % by weight, based on the total amount of the monomers.

As the component a), either an alkyl (meth)acrylate having 2 to 14 carbon atoms on average in the alkyl group either alone or a mixture of the alkyl (meth)acrylate and a monomer for modification copolymerizable therewith can be used as it is. Alternatively, partially polymerized products thereof (i.e., oligomers) may be used to improve the coating workability, etc., so long as the adhesion characteristics are not deteriorated. Also, marketed oligomers or thickeners such as polyols or polyethers may be used for the same purpose.

The polyfunctional (meth)acrylate, a crosslinking agent as the component b), is added to increase the shear strength of the pressure-sensitive adhesive composition after the completion of polymerization. Examples thereof include trimethylolpropane tri(meth)acrylate, pentaerythritol tetra(meth)acrylate, 1,2-ethylene glycol di(meth)acrylate and 1,6-hexanediol di(meth)acrylate. The polyfunctional (meth)acrylate is added generally in an amount of from 0.02 to 5 parts by weight, preferably from 0.1 to 3 parts by weight, per 100 parts by weight of the monomer or partially polymerized product as the component a). It is recommended that a difunctional (meth)acrylate is employed in a somewhat large amount while a trifunctional or higher one is employed in a somewhat small amount, within the scope as defined above. When its content is less than 0.02 parts by weight, any sufficiently high degree of crosslinkage may not be achieved after polymerization. On the other hand, when its content exceeds 5 parts by weight, some problems such as a decrease in tackiness may be caused.

Examples of the photopolymerization initiator as the component c) include: benzoin ethers such as benzomethyl ether and benzoin isopropyl ether; substituted benzoin ethers such as anizoin methyl ether; substituted acetophenones such as 2,2-diethoxyacetophenone and 2,2-dimethoxy-2-phenoneacetophenone; substituted α-ketols such as 2-methyl-2-hydroxypropiopheone; aromatic sulfonyl chlorides such as 2-naphthalene sulfonyl chloride; and optically active oxime compounds such as 1-phenone-1,1-propanedione-2-(o-ethoxycarbonyl)oxime. The photopolymerization initiator is used generally in an amount of from 0.01 to 5 parts by weight, preferably from 0.05 to 1 part by weight, per 100 parts by weight of the monomer optionally having been polymerized partially employed as the component a). When its content is smaller than 0.01 part by weight, much monomer is liable to remain unpolymerized. On the other hand, when it exceeds 5 parts by weight, the molecular weight of the resultant polymer is liable to be lowered, thereby lowering the cohesive force of the pressure-sensitive adhesive composition.

The heat-conductive, electrical insulating filler as component d) is used to impart a good heat conductivity to the pressure-sensitive adhesive composition. Examples thereof include ceramics and metal oxides having electrical insulating properties such as $SiO_2$, $TiB_2$, BN, $Si_3N_4$, $TiO_2$, MgO, NiO, CuO, $Al_2O_3$, and $Fe_2O_3$. Such a filler has an average particle diameter of from 0.5 to 250 $\mu$m, preferably from 1 to 100 $\mu$m and still preferably from 2 to 10 $\mu$m. These particles may be in any form such as spheres, needles, flakes or stars. From the viewpoint of avoiding an increase in the viscosity of the pressure-sensitive adhesive composition, it is preferable that such a filler has a purity of at least 95 % by weight. It is used in an amount of from 10 to 300 parts by weight, preferably from 10 to 120 parts by weight, per 100 parts by weight of the monomer optionally having been polymerized partially which is used as component a). When the content is smaller than 10 parts by weight, there is a possibility that desired effect on the heat conductivity can not be achieved. When it exceeds 300 parts by weight, there is a possibility that the adhesion is deteriorated and the adhesion force is lowered, in particular, at high temperatures.

In addition to the above-mentioned components a) to d), the heat-conductive and pressure-sensitive adhesive composition may contain various known additives such as pigments, age resistors and tackifiers. Furthermore, the composition may contain an external crosslinking agent and then may be subjected to crosslinking treatment so as to further increase the cohesive force after the completion of polymerization. Examples of the external crosslinking agent include polyfunctional isocyanate crosslinking agents such as tolylene diisocyanate, trimethylolpropane tolylene diisocyanate and diphenylmethane triisocyanate; epoxy crosslinking agents such as polyethylene glycol diglycidyl ether, diglycidyl ether and trimethylolpropane triglycidyl ether; melamine resin crosslinking agents; metallic salt crosslinking agents; metallic chelate crosslinking agents; amino resin crosslinking agents; and peroxide crosslinking agents.

The polymerizable composition comprising these components can be usually prepared by mixing the monomer as component a) with the photopolymerization initiator as component c); partially polymerising the resultant premix to obtain a coatable syrup having a viscosity of 500 to 5,000 cP; then adding the polyfunctional (meth)acrylate (i.e., the crosslinking agent) as component b) and the heat-conductive, electrical insulating filler as component d), optionally together with the photopolymerization initiator and other arbitrary components as described above; and then mixing the resulting blend.

In the present invention, the polymerizable composition prepared above is applied onto the high frequency sputter-etched surface(s) of the electrical insulating plastic film. Then, the composition is polymerized with the irradiation of UV or radiation to form a layer of the heat-conductive and pressure-sensitive adhesive composition containing the alkyl (meth)acrylate polymer and having a thickness of from 5 to 300 $\mu$m, preferably from 10 to 150 $\mu$m, thus obtaining heat-conductive and pressure-sensitive adhesive sheets in the form of sheets or tapes.

The UV or radiation to be used in the polymerization is generally electromagnetic rays having a wavelength of from about 180 to 460 nm. However, those having longer or shorter wavelength are also usable. It is desirable that the UV-irradiation is performed in an oxygen-free atmosphere (replaced with an inert gas such as nitrogen) or in an air-blocked state with the use of an UV-permeable film, etc. Examples of the UV source include commonly employed irradiation sources such as mercury arcs, carbon arcs, low-pressure mercury lamps, medium/high pressure mercury lamps and metal halide lamps. The intensity of the UV light can be appropriately regulated by controlling the distance to the material to be irradiated and the electrical voltage, but it is preferable to use rays of 0.1 to 7 mW/cm$^2$, taking the anchoring effect into consideration. Examples of the radiation include actinic energy beams, ionizing radiation such as $\alpha$-beam, $\beta$-beam, $\gamma$-beam, neutron beam and accelerated electron beam. The irradiation dose preferably ranges from 1 to 10 Mrad. It is also possible to irradiate the polymerizable composition with both of UV light and radiation.

As discussed above, the layer of the heat-conductive and pressure-sensitive adhesive composition containing the alkyl (meth)acrylate polymer thus formed undergoes into the interaction with the hydrophilic groups formed on the high-frequency sputter-etched surface(s) of the electrical insulating plastic film employed as the base material. In the course of polymerization, the adhesive composition is chemically bonded to the hydrophilic groups, thus achieving a excellent adhesion to the base material. As a result, any anchoring fracture scarcely arises between the adhesive layer and the base material and an improved heat resistance is established. Moreover, the heat-conductive and pressure-sensitive adhesive composition layer is substantially free from any organic solvent, since it is made from the organic solvent-free polymerizable composition. Accordingly, there arises no problem attributable to organic solvents such as corrosion of electronic parts due to organic solvents or swelling, peeling or deviation caused by vaporization and expansion at high temperatures.

In order to adhere and fix electronic parts to heat-radiating members by using these heat-conductive and pressure-sensitive adhesive sheets according to the present invention, the heat-conductive and pressure-sensitive adhesive sheets are inserted between the electronic parts and the heat-radiating members, followed by contact bonding, making use of the pressure-sensitive adhesion. Thus, the electronic parts and the heat-radiating members can be well fixed while achieving a high heat-conductivity and a high adhesion strength even at high temperatures.

The electronic parts to be adhered and fixed are not particularly restricted. Examples thereof include IC tips, hybrid packages, multi-tip modules, power transistors and sealed integrated circuits made of plastics or metals. The present invention can be advantageously applied to the adhesion and fixation of electronic parts with a large heating value, for example, those employed in highly integrated IC circuits.

The heat-radiating members, i.e., another subject to be adhered and fixed, are exemplified by heat sinks made of metal plates and sheets and radiators. The thickness of the heat sinks generally ranges from 10 $\mu$m to 10 mm, preferably from 100 $\mu$m to 3 mm, though the present invention is not restricted thereto. The radiators may have arbitrary structures, for example, those provided with cooling fins.

The heat-conductive and pressure-sensitive adhesive sheets of the present invention may be used not only in adhering and fixing these electronic parts to the heat-radiating members but also in fixing members in various fields including building materials, vehicles, aircrafts and ships. The heat-conductive and pressure-sensitive adhesive sheets can achieve the above-mentioned effects when employed for these purposes.

To further illustrate the present invention in greater detail, the following Examples will be given wherein all parts are by weight.

Example 1

A premix consisting of 75 parts of isooctyl acrylate, 20 parts of butyl acrylate, 5 parts of acrylic acid and 0.1 part of 2,2-dimethoxy-2-phenylacetone employed as a photopolymerization initiator was partially polymerized by exposing to UV light in a nitrogen atmosphere to obtain a coatable syrup having a viscosity of about 40 P (poise). To 100 parts of this syrup were added 0.2 parts of trimethylolpropane triacrylate employed as a crosslinking agent and 40 parts of boron nitride (BN; purity 99.7 % by weight, average particle diameter 8 $\mu$m) employed as a heat-conductive, electrical insulating filler, followed by mixing, to obtain a polymerizable composition.

Separately, high frequency sputter etching was performed on the both surfaces of a base material, which was a polyimide film having a thickness of 25 $\mu$m, by applying high frequency voltage of 13.6 MHz under an oxygen gas atmosphere at 0.005 Torr while regulating the discharge power at 4 Watt/cm$^2$ for 30 seconds.

Next, the polymerizable composition prepared above was applied onto the sputter-etched surfaces of this base material. Then, photopolymerization was performed by UV-irradiating it with a high pressure mercury lamp at 900 mj/cm$^2$ at 5 mW/cm$^2$ in a nitrogen gas atmosphere, followed by drying in a hot air circulatory dryer (130 °C, 5 minutes), to form a layer of a heat-conductive and pressure-sensitive adhesive composition containing the alkyl (meth)acrylate polymer having a thickness of 50 $\mu$m on each surface. Thus, a heat-conductive and pressure-sensitive adhesive sheet having a total thickness of 125 $\mu$m was prepared.

Comparative Example 1

A heat-conductive and pressure-sensitive adhesive sheet having a total thickness of 125 $\mu$m was prepared in the same manner as in Example 1 except for performing no high frequency sputter etching on the both surfaces of the base material made of a polyimide film.

Comparative Example 2

The polymerizable composition prepared in Example 1 was applied onto a polyester film which had been surface-treated with a releasing agent. Then, photopolymerization was performed by UV-irradiating it with a high pressure mercury lamp at 900 mj/cm$^2$ at 5 mW/cm$^2$ in a nitrogen gas atmosphere, followed by drying in a hot air circulatory dryer (130 °C, 5 minutes), to form a layer of a heat-conductive and pressure-sensitive adhesive containing the alkyl (meth)acrylate polymer having a thickness of 50 $\mu$m.

Separately, high frequency sputter etching was performed on the both surfaces of a base material, which was a polyimide film having a thickness of 25 $\mu$m, by applying high frequency voltage of 13.6 MHz under a steam atmosphere at 0.005 Torr while regulating the discharge power at 4 Watt/cm$^2$ for 30 seconds. Then, the heat-conductive and pressure-sensitive adhesive composition layer (thickness: 50 $\mu$m) prepared above was transferred onto the both surfaces (i.e., sputter-etched surfaces) of this base material to obtain a heat-conductive and pressure-sensitive adhesive sheet having a total thickness of 125 $\mu$m.

Example 2

A premix consisting of 85 parts of 2-ethylhexyl acrylate, 5 parts of acrylic acid, 10 parts of caprolactam-modified acrylate (ARONIX M-5300™ manufactured by Toagosei Co., Ltd.) and 0.1 part of 2,2-dimethoxy-2-phenylacetone employed as a photopolymerization initiator was partially polymerized by exposing to UV light in a nitrogen atmosphere to give a coatable syrup having a viscosity of about 40 P. To 100 parts of this syrup were added 0.2 parts of trimethylolpropane triacrylate employed as a crosslinking agent and 40 parts of boron nitride (BN; purity 99.7 % by weight, average particle diameter 8 $\mu$m) employed as a heat-conductive, electrical insulating filler, followed by mixing, to obtain a polymerizable composition.

Separately, high frequency sputter etching was performed on the both surfaces of a base material, which was a polyimide film containing having a thickness of 25 $\mu$m, by applying high frequency voltage of 13.6 MHz under a steam atmosphere at 0.005 Torr while regulating the discharge power at 4 Watt/cm$^2$ for 30 seconds.

The polymerizable composition prepared above was applied onto the sputter-etched surfaces of this base material. Then, photopolymerization was performed by UV-irradiating it with a high pressure mercury lamp at 900 mj/cm$^2$ at 5 mW/cm$^2$ in a nitrogen gas atmosphere, followed by drying in a hot air circulatory dryer (130 °C, 5 minutes), to thereby form a layer of a heat-conductive and pressure-sensitive adhesive composition containing the alkyl (meth)acrylate polymer having a thickness of 50 $\mu$m on each surface. Thus, a heat-conductive and pressure-sensitive adhesive sheet having a total thickness of 125 $\mu$m was prepared.

Comparative Example 3

A heat-conductive and pressure-sensitive adhesive sheet having a total thickness of 125 $\mu$m was prepared in the same manner as in Example 2 except for performing no high frequency sputter etching on the both surfaces of the base material made of a polyimide film.

Example 3

A polymerizable composition was prepared in the same manner as in Example 2 except for using 80 parts of 2-ethylhexyl acrylate and 20 parts of butyl acrylate. By using this polymerizable composition, the procedure of Example 2 was repeated to obtain a heat-conductive and pressure-sensitive adhesive sheet having a total thickness of 125 $\mu$m.

Example 4

A polyimide film containing 18 % by volume of alumina (Al$_2$O$_3$; purity 99.7 % by weight, average particle diameter 3.7 $\mu$m) as a heat-conductive, electrical insulating filler and having a thickness of 28 $\mu$m was used as a base film. High frequency sputter etching was performed on both surfaces of this base film in the same manner as in Example 1.

The same polymerizable composition as in Example 1 was applied onto the both sputter-etched surfaces of this base film, followed by the same treatment as in Example 1. Thus, a layer of a pressure-sensitive adhesive composition containing the alkyl (meth)acrylate polymer of 50 $\mu$m in thickness was formed on each surface to obtain a heat-conductive and pressure-sensitive adhesive sheet of 128 $\mu$m in total thickness.

Comparative Example 4

A heat-conductive and pressure-sensitive adhesive sheet having a total thickness of 128 $\mu$m was prepared in the same manner as in Example 4 except for performing no high frequency sputter etching on the both surfaces of the base material made of a polyimide film containing the heat-conductive, electrical insulating filler.

Comparative Example 5

A polyimide film containing 18 % by volume of alumina (Al$_2$O$_3$; purity 99.7 % by weight, average particle diameter 3.7 $\mu$m) as a heat-conductive, electrical insulating filler and having a thickness of 28 $\mu$m was used as a base film. High frequency sputter etching was performed on both surfaces of this base film in the same manner as in Example 1. Then, the same layer of the heat-conductive and pressure-sensitive adhesive composition having a thickness of 50 $\mu$m as obtained in Comparative Example 2 was transferred onto each sputter-etched surface to obtain a heat-conductive and pressure-sensitive adhesive sheet having a total thickness of 128 $\mu$m.

The heat-conductive and pressure-sensitive adhesive sheets obtained in the above Examples 1 to 4 and Comparative Examples 1 to 5 each were evaluated in terms of retentive force resistant to heat shear and heat resistance according to the following methods. The obtained results are shown in Table below.

Retentive Force Resistant to Heat Shear Test

A heat-conductive and pressure-sensitive adhesive sheet (width: 10 mm) was adhered to one lengthwise end of an aluminum plate (125 x 25 x 0.4 mm) to obtain an adhesion area of 20 x 10 mm. After allowing to stand at 80 °C for 30 minutes, a load (500 g or 1,000 g) was applied thereon at 80 °C to examine whether the sheet dropped within 120 minutes or not. Samples held for 120 minutes or longer were rated as "A", while those dropped within 120 minutes were rated as "B".

Heat Resistance Test

By using a heat-conductive and pressure-sensitive adhesive sheet, a transistor in a TO-220 package (in terms of a standard of Joint Electron Device Engineering Council) was adhered and fixed under a contact bonding pressure of 2 kg/cm$^2$ to a heat sink which had been immersed in water to obtain a constant temperature. Then a definite output was supplied to the transistor and the difference in the transistor temperature (T2) from the temperature of the lower surface of the heat-conductive and pressure-sensitive adhesive sheet (T1) was measured. Next, the heat resistance was calculated in accordance with the following formula.

$$\text{Heat resistance } (°C \cdot cm^2/W) = (T2 - T1) \times A/P$$

A:    transistor area (cm$^2$).
P:    electrical power (W) consumed by transistor.

The transistor temperature (T2) was measured by using a thermocouple spot-welded to the metallic base of the transistor package. On the other hand, the temperature of the lower surface of the heat-conductive and pressure-sensitive adhesive sheet (T1) was measured by forming a small hole in the heat sink and inserting a thermocouple thereinto. The thermocouple was placed in the heat sink such that it did not give influence onto the adhered area of the heat-conductive and pressure-sensitive adhesive sheet, with the proviso that the location of the thermocouple was as near as possible to the interface between the heat sink and the adhesive sheet.

TABLE

|  | Retentive Force Resistant to Heat Shear Test | | Heat Resistance Test ($°C \cdot cm^2/W$) |
|---|---|---|---|
|  | Load 500 g | Load 1,000 g |  |
| Example 1 | A | A | 6.0 |
| Comparative Example 1 | B | B | 6.0 |
| Comparative Example 2 | A | B | 6.0 |
| Example 2 | A | A | 6.5 |
| Comparative Example 3 | B | B | 6.5 |
| Example 3 | A | A | 6.0 |
| Example 4 | A | A | 4.3 |
| Comparative Example 4 | B | B | 4.3 |
| Comparative Example 5 | A | B | 4.3 |

It can be seen from the results shown in the above Table that the heat-conductive and pressure-sensitive adhesive sheets of Examples 1 to 4 according to the present invention each were not only held for more than 120 minutes in the retentive force resistant to heat shear test even under a load of 1,000 g but also achieved satisfactory results in the heat resistance test.

On the other hand, the heat-conductive and pressure-sensitive adhesive sheets of Comparative Examples 1, 3 and 4, which were prepared without performing high frequency sputter etching, each dropped within 120 minutes in the retentive force resistant to heat shear test under a load of 500 g, and the heat-conductive and pressure-sensitive adhesive sheets of Comparative Examples 2 and 5, which were prepared without directly applying the polymerizable composition on the sputter-etched surfaces and then polymerizing the same while effecting high frequency sputter etching, each dropped within 120 minutes in the retentive force resistant to heat shear test under a load of 1,000 g. These samples dropped due to the anchoring fracture between the base material and the adhesive layer.

As described above, the present invention makes it possible to produce heat-conductive and pressure-sensitive adhesive sheets being excellent in heat resistance and free from any troubles such as corrosion of electronic parts due to organic solvents or swelling, peeling or deviation caused by vaporization and expansion at high temperatures, having excellent adhesion between the adhesive layer and the base material and thus scarcely undergoing anchoring fracture between the base material and the adhesive layer, by applying a polymerizable composition containing an acrylic monomer as the main component onto the high frequency sputter-etched surface(s) of an electrical insulating plastic film and polymerizing the composition with the irradiation of UV or radiation to thereby form a layer of an acrylic heat-conductive and pressure-sensitive adhesive composition. These heat-conductive and pressure-sensitive adhesive sheets are widely usable in fixing electronic parts, in particular, fixing electronic parts to heat-radiating members, or fixing members in various fields including building materials, vehicles, aircrafts and ships.

While the invention has been described in detail and with reference to specific embodiments thereof, it will be apparent to one skilled in the art that various changes and modifications can be made therein without departing from the spirit and scope thereof.

## Claims

1. A method for producing heat-conductive and pressure-sensitive adhesive sheets which comprises high-frequency sputter etching one or both of the surfaces of an electrical insulating plastic film, applying a polymerizable composition containing a monomer containing an alkyl (meth)acrylate as the main component or a partially polymerized product of the monomer, onto the sputter-etched surface(s), and polymerizing the monomer or the partially polymerized product with UV-irradiation or radiation to thereby form a layer of a heat-conductive and pressure-sensitive adhesive composition containing the alkyl (meth)acrylate polymer.

2. The method for producing heat-conductive and pressure-sensitive adhesive sheets of claim 1, wherein said the polymerizable composition further contains a heat-conductive, electrical insulating filler.

3. The method for producing heat-conductive and pressure-sensitive adhesive sheets of claim 1, wherein said electrical insulating plastic film is a polyimide(amide) film.

4. The method for producing heat-conductive and pressure-sensitive adhesive sheets of claim 1, wherein said electrical insulating plastic film is one containing from 2 to 50 % by volume of a heat-conductive, electrical insulating filler.

5. The method for producing heat-conductive and pressure-sensitive adhesive sheets of claim 1, wherein said high frequency sputter etching is performed under an atmospheric pressure of 0.0005 to 0.5 Torr.

6. The method for producing heat-conductive and pressure-sensitive adhesive sheets of claim 1, wherein said polymerizable composition is one composed of: a) 100 parts by weight of a monomer which comprises from 70 to 100 % by weight of an alkyl (meth)acrylate having 2 to 14, on average, carbon atoms in the alkyl group and from 0 to 30 % by weight of a monomer for modification copolymerizable therewith or a partially polymerized product of the monomer; b) from 0.02 to 5 parts by weight of a polyfunctional (meth)acrylate as a crosslinking agent; c) from 0.01 to 5 parts by weight of a photopolymerization initiator; and d) from 10 to 300 parts by weight of a heat-conductive, electrical insulating filler.

**European Patent Office**

## EUROPEAN SEARCH REPORT

Application Number

EP 98 10 6970

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | DATABASE WPI<br>Derwent Publications Ltd., London, GB;<br> AN 86-321559<br>XP002071516<br>& JP 61 236 882 A (SHINETSU CHEM. IND. CO. LTD.) , 22 October 1986<br>* abstract * | 1-4,6 | C09J7/02<br>C09J5/02<br>C08F20/18<br>H05K7/20<br>H01L23/373 |
| Y,D | EP 0 566 093 A (MINNESOTA MINING & MFG) 20 October 1993<br>* page 3, line 11 - line 57 *<br>* page 4, line 28 - line 39 *<br>* examples *<br>* claims 1,7 * | 1-4,6 | |
| A | DATABASE WPI<br>Derwent Publications Ltd., London, GB;<br> AN 84-167938<br>XP002071517<br>& JP 59 091 182 A (NITTO ELECTRIC IND. CO.) , 25 May 1984<br>* abstract * | 1,6 | |
| A | DATABASE WPI<br>Derwent Publications Ltd., London, GB;<br> AN 80-78233c<br>XP002071518<br>& JP 51 119 733 A (NITTO ELECTRIC IND. CO.) , 20 October 1976<br>* abstract * | 1,5 | TECHNICAL FIELDS SEARCHED (Int.Cl.6)<br><br>C09J<br>C08F<br>H05K<br>H01L |

The present search report has been drawn up for all claims

| Place of search | Date of completion of the search | Examiner |
|---|---|---|
| THE HAGUE | 22 July 1998 | Bettels, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)